# EUROPEAN PATENT APPLICATION

(11) **EP 2 953 259 A1**
(43) Date of publication of application: **09.12.2015**
(21) Application number: 15170907.8
(22) Date of filing: 05.06.2015
(51) Int. Cl.: H02N 2/18, H01L 41/113

(54) **DEVICE MADE OF PIEZOELECTRIC MATERIAL HAVING A FIN FOR HARVESTING ENERGY FROM AIR FLOWS**

(30) Priority: 05.06.2014 IT RM20140291
(71) Applicant: StronGER S.r.l., 00123 Roma (IT)
(72) Inventor: BONTEMPI, Franco, I-39100 Bolzano (IT); CROSTI, Chiara, I-05100 Terni (TR) (IT); GKOUMAS, Konstantinos, I-00100 Roma (IT); PETRINI, Francesco, I-00018 Palombara Sabina (RM) (IT); ARANGIO, Stefania, I-00100 Roma (IT)
(74) Representative: Fezzardi, Antonio

(57) **Abstract**

The subject of the present invention is a device that is able to harvest energy from air flows present in either open and closed environments, from natural or artificial sources. The invention basically consists of a piezoelectric element appropriately attached to an aerodynamic appendage specifically sized in shape and in mechanical characteristics for exploiting a specific effect of the flow of air (in particular, one of the effects referred to technically as "vortex shedding", "flutter", or else "turbulent-flow-induced vibrations") for the production of electrical energy. In the example of embodiment referred to in the present description, the device is mainly conceived as an element of a wireless building automation network integrated with a temperature sensor, for specific applications within air-conditioning ducts in which the aforesaid vortex-shedding phenomenon is exploited.

## Description

### Summary of the invention

The subject of the present invention is a device that is able to harvest energy from air flows present in either open or closed environments, from natural or artificial sources. The invention basically consists of a piezoelectric element appropriately attached to an aerodynamic appendage specifically sized as regards shape and mechanical characteristics to exploit a specific effect of the flow of air (in particular, one of the effects referred to technically as "vortex shedding", "galloping", "flutter", and "turbulent-flow-induced vibrations") for the production of electrical energy. In the example of embodiment referred to in the present description, the device is conceived mainly as an element of a wireless building automation network integrated with a temperature sensor, for specific applications within air-conditioning ducts in which the aforesaid vortex-shedding phenomenon is exploited. If appropriately sized in its basic elements, the invention can be used for harvesting energy from air flows also in other applications, both for indoor and outdoor air flows.

In what follows, with reference to the attached figures, there now follows a description of the prior art and of a preferred embodiment of the invention, which is to be understood purely by way of non-limiting example.

In the drawings:
Figure 1 shows an example of oscillating piezoelectric generator of a known type;
Figure 2 is a schematic representation of a possible configuration of assembly of the invention;
Figure 3 shows a block diagram representing operation of the conversion of the energy of the flow of air into electrical energy;
Figure 4 shows an example of possible configuration of the invention with a piezoelectric element of the patch type;
Figure 5 shows an example of possible configuration of the invention with a piezoelectric element of the free-standing thick-film type;
Figure 6 is a top plan view corresponding to the examples of Figures 4 and 5;
Figure 7 illustrates a possible installation of the invention within an air duct; and
Figure 8 illustrates a possible installation of the invention alongside traffic lanes on viaducts or in tunnels.

### Description of the prior art

The prior art regarding use of configurations of elements made of piezoelectric material subject to vibrations for energy harvesting is sufficiently extensive. Different, instead, is the situation of the prior art regarding use of configurations that exploit the air flow, and even moreso the effect of vortex shedding, for energy harvesting.

**Energy harvesting** (also known as "power harvesting" or "energy scavenging") is the process whereby the energy, coming from alternative sources, is captured and stored. The so-called alternative forms of energy are all those sources commonly available in the environment. This process converts them into electrical energy that can be used directly.

Energy harvesting is a sector of research that has had considerable commercial spinoffs in the last few years, in particular in the military, aeronautics, and aerospace sectors, and finally in the sector of civil engineering. For instance, some areas of application are those of building automation and structural monitoring of extensive buildings. In both cases, there exists the need to supply energy to sensors located inside or outside of buildings, structures, and infrastructures, so as to get them to function autonomously without the use of batteries or of an electric mains supply for supplying them. The characteristic of producing a difference of potential following upon compression has several industrial applications.

**Piezoelectricity** is the property of some crystals to generate a difference of potential when they undergo mechanical deformation. This effect is reversible and occurs on a scale of the order of nanometers. Operation of a piezoelectric crystal is quite simple: when an external pressure (or negative pressure) is applied, charges of opposite sign position themselves on the opposite faces. The crystal thus behaves like a capacitor to which a difference of potential has been applied. If the two faces are connected via an external circuit, an electric current, referred to as "piezoelectric current" is thus generated. Harvesting vibrational mechanical energy using piezoelectric materials is one of the methods that enable a higher energy production.

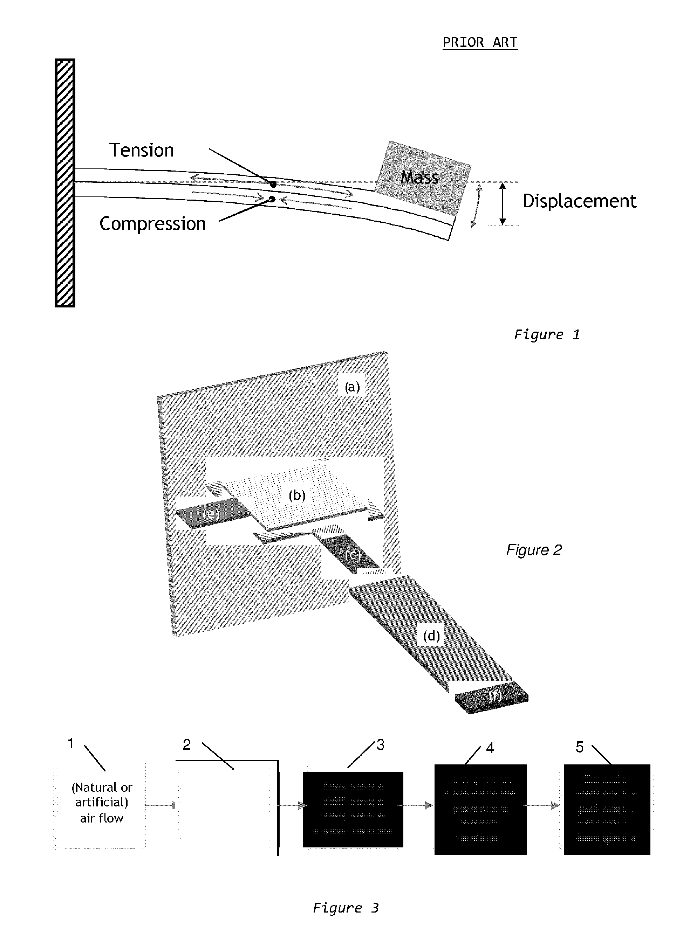

The most widespread configuration for this type of energy harvesting is the **beam** configuration (Figure 1): a plate made of piezoelectric material is anchored at one end to the load-bearing structure and at the other to a mass that is free to oscillate. The movements of the mass induce on the piezoelectric beam tensile and compressive stresses, which constitute the mechanical stresses responsible for effective production of electrical energy. Continuous oscillation about a position of static equilibrium ensures the production of alternating current.

As an alternative to exploitation of the vibrations generated by the inertia of the oscillating mass, it is possible to exploit other methods to get a system of the type referred to above to oscillate. One of these is precisely exploitation of a flow of air. In particular, researches have been carried out that exploit the vortex-**shedding** phenomenon.

**Vortex shedding** is an aeroelastic phenomenon in which, if a body is immersed in a subsonic fluid current, a wake of vortices is formed that detach from the body itself in an alternating and non-stationary way. Vortex shedding generates forces of resistance and lift that are variable in time, even if the velocity of the incident vein of fluid has a constant intensity and direction. This excitation phenomenon occurs for profiles where the vein tends to detach, i.e., for bodies that do not have a cross section of a winglike type, such as for example circular ones. In the case where particular conditions arise, the frequency of vortex shedding may synchronize with the resonance frequency of the structure, thus creating a synchronism (or lock-in) that increases the intensity of the force of lift.

It should be pointed out that the lock-in phenomenon, referred to in the present description, is a phenomenon of aeroelastic instability that is set up when the vortex-shedding frequency is equal to the transverse vibration frequency of the vibrating body immersed in the fluid. In this situation, where the vortices detach in resonance conditions from the structure, it is no longer vortex shedding that excites the structure, but, instead, it is the structure that governs the frequency and amplitude of shedding of the vortices, which in turn produce greater forces on the structure. This is an aeroelastic "self-excitation" phenomenon that can give rise to phenomena of amplification of the oscillations, which may even be very considerable.

In other words, lock-in regards the coupled fluid-structure system, i.e., the aeroelastic self-excitation phenomenon described previously, where it is the structure that determines the vortex-shedding configuration, with consequent considerable amplification of the oscillations.

Wu *et al.* (2013) have presented numerical studies on a cantilever provided with a piezoelectric patch and completed by a proof mass. The authors have investigated the influence of the length and position of the patch, of the intensity of the flow of air, and of the weight of the mass. The device is preferably positioned with its major surface set perpendicular to the flow of air.

Weinstein *et al.* (2012) have studied the prototype of a configuration based upon a cantilever with piezoelectric material attached at one end (to the base). In this case, a fin is attached at the other end, to exploit the vortex-shedding phenomenon. For generation of the vortices, a bluff-body is used to amplify the effect of vortex shedding. The prototype has been specifically devised and tested for applications within pipes of HVAC (Heating, Ventilation, and Air-Conditioning) systems. In HVAC pipes, the flow of air is practically homogeneous with rates that prevalently range between 2.5 and 5.0 m/s².

The present invention differs from the studies referred to above mainly for the different configuration of the assembly and of the positioning with respect to the flow of air.

Also known from US 2010/076714 is a generic system of self-supplied sensors that monitors the conditions or parameters of an environment. In this document, however, reference is simply made to harvesting of energy from induced vibrations.

In US 2010/076714 no mention or reference is made to the use of specific aerodynamic phenomena, such as vortex shedding, flutter, and/or turbulent-flow-induced vibrations generated by air flows present in the environments in which the sensors are installed.

WO 2014/013638 describes a device that uses a piezoelectric material for harvesting energy by exploiting induced vibrations. This document focuses attention on the characteristics of the electrical circuit, which may envisage the use of a wireless circuit, the capacity of storing electrical energy, and the use of a wireless protocol. Unlike WO 2014/013638, the present invention does not regard design of the electrical circuit.

It should moreover be noted that, unlike US 2010/076714 and WO 2014/013638, the present invention specifically exploits the vibrations induced by vortex shedding and/or flutter. This is not a trivial choice of implementation in so far as the phenomenon is very particular from the mechanical standpoint because in the lock-in condition of the vibrating system, i.e., the phenomenon whereby the vortex-shedding frequency is close to the natural frequency of the oscillating system, the amount of energy harvested by the device according to the invention is much higher (by more than one order of magnitude) as compared to known systems.

DE 10 2009 030718 describes a device for harvesting energy from applications where a flow is present, such as for example the ventilation systems of buildings. Basically, this document describes a device that substantially envisages use of a thin piezoelectric film that can be associated to an element that generates the turbulence necessary for getting the piezoelectric film to vibrate. Various possible applications are moreover described, amongst which the possibility of fixing the other end of the piezoelectric film so that it can work as a membrane.

As a whole, the device of DE 10 2009 030718 differs from the device according to the present invention from many points of view. In the first place, said known device does not use or mention vortex shedding and/or the flutter effect, and consequently, even though some components may be considered similar, the device of DE 10 2009 030718 is based upon an operating principle that is completely different from that of the present invention.

US 2013/119669 describes a device for harvesting energy from air flows that uses magnetostrictive materials. It uses the vibrations induced by turbulence or by vortices of the flow in which it is located. In addition to the use of magnetostrictive materials, also the possibility of increasing the energy harvested using a permanent magnet is envisaged.

Unlike the present invention, the device described in US 2013/119669 can be used in a flow that proceeds in a direction parallel to the major dimension of the device itself, which is specifically indicated for being used inside pipes of small section, with fluids that are denser and heavier than air (e.g. oil).

Amongst other things, the geometry proposed for the device of US 2013/119669 is altogether misleading for the purposes of the present invention in so far as it is not suited for being used with flows of light fluids such as air.

### Detailed description of the invention

The present invention basically regards a self-supplied device for detection of environmental and/or structural parameters and for sending said data in wireless mode, which comprises, in combination, the following parts (Figure 2):
a. a base made of rigid material that serves as support of all the components;
b. an element comprising a first module for wireless communication and a second module for energy storage;
c. at least one piezoelectric element constituted by typical energy-harvesting materials, such as for example BaTiO₃, PZT-5A, PZT-5H, polyvinylidene fluoride (PVDF), etc; the technologies that can be used are of the free-standing thick-film type or else the free-standing thin-film type, i.e., piezoelectric films with different configurations;
d. a fin having appropriate dimensions, shape, and mechanical characteristics, which serves to maximize the effect of vortex shedding and is mechanically connected to said piezoelectric element to cause it to undergo deformation when it is subjected to aerodynamic forces;
e. a sensor chosen according to the specific desired application: it may be an environmental sensor such as a temperature and humidity probe for use in HVAC pipes, or else a sensor for structural monitoring, for example an accelerometer; and
f. a possible additional mass made of appropriate material, which in the preferred embodiment described is sized, as regards geometry and mass density of the constituent material, for the purpose of adjusting appropriately the natural frequency of oscillation of the oscillating parts.

In the complete configuration of the element "b", the first module serves for uni- or bi-directional transmission of data detected by the sensor "e" to a wireless transmitter and/or receiver connected to a data-storage system; the second module serves to store the electrical energy produced (this module could be constituted, for example, by one or more batteries or capacitors).

In its commercial form, the device could be equipped with a casing that covers the elements "b" and "e" partially or totally.

Energy harvesting and its conversion into electrical energy according to the present invention functions according to the block diagram appearing in Figure 3.

The invention is based upon block 2 "Conversion of air flow into mechanical energy". In fact, according to the characteristics of the flow of air (block 1) and the performance requirements in terms of energy produced, the appropriate piezoelectric element is chosen from among those commercially available or as "made to order", and the constructional characteristics of the fin (dimensions, shape, and material) are identified in such a way that the geometry is the one most suited for energy harvesting.

In effect, the aforesaid constructional characteristics of the fin and those of the piezoelectric element must be such as to guarantee the effect of lock-in of the vibrating system, i.e., the phenomenon whereby the vortex-shedding frequency approaches the natural frequency of the system: in fact, only in this case the vibrations (and hence the energy produced) are maximum.

In other words, is may be said that the fin is devised with appropriate dimensions and shape, according to the aeroelastic phenomenon that is to be exploited (vortex shedding, or galloping, flutter, or air-flow turbulence).

The remaining three blocks of the diagram represented in Figure 3 regard:
- block 3: conversion of mechanical energy into electrical energy (alternating current);
- block 4: conversion of alternating current into direct current; and
- block 5: use and/or storage of energy harvested.

For practical implementation of the above blocks it is possible to resort to widely used and consolidated technologies.

It should be noted that the configuration represented schematically in Figure 2 is provided purely by way of indication. The part referred to hereinafter as "active", i.e., the part that contains the piezoelectric material, identified in Figure 2 by the reference (c), could be obtained with various technologies of construction.

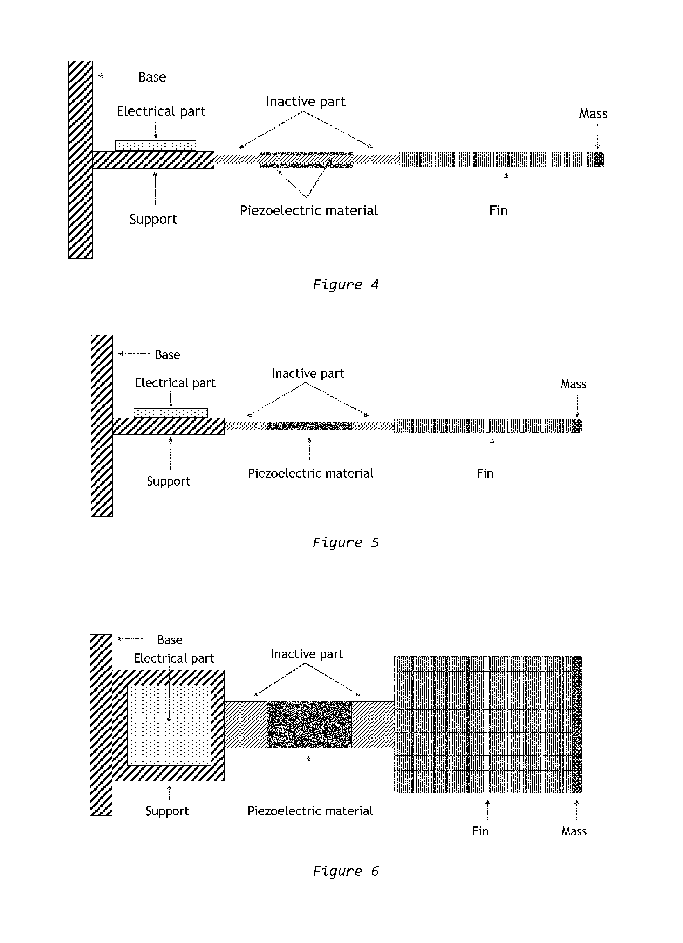

Preferably this part of the invention is constituted by:
a. piezoelectric material of the patch type, i.e., in the form of an adhesive layer, attached on a flexible element (on one or both sides), as represented in Figure 4; or else
b. piezoelectric material of the free-standing type, i.e., in the form of a self-supporting piezoelectric element, as represented in Figure 5, possibly including other elements (for example, an electrical circuit).

Figure 6 is a top plan view of the aforesaid configurations. It should be noted that the dimensional ratios between the elements in the aforesaid figures are only indicative and not in scale.

In the tests conducted, a device integrated with a temperature sensor or a temperature and humidity sensor "e" was obtained for carrying out monitoring of the conditions of the air (mainly temperature and humidity) in HVAC ducts and piping for the purposes of optimization of consumption of the HVAC systems themselves. The flow of air found in operation during testing in this configuration was of a laminar type at average rates typically of between 2 and 5 m/s.

According to a peculiar characteristic of the invention, the device is positioned so as to have the major surface of the fin "d" set parallel to the flow and the major length of the fin itself set parallel to the flow.

It is also possible to envisage that said temperature sensor and/or humidity sensor "e" is replaced or accompanied by another type of sensor, such as for example a sensor for monitoring the chemical substances in the air.

As has already been mentioned, the sensors installed on the device may also be of a type not strictly connected to control of the environmental air, such as for example typical sensors for structural monitoring.

In the case where the invention is installed alongside traffic lanes, roads and/or railway lines, the flow of air found during testing in this configuration was of a turbulent type with gusts caused by the passage of vehicles in the proximity.

It should be noted that, in the case where the amount of energy produced is "compatible" in quantitative terms, it is also possible to use said energy for total or partial supply of electrical devices other than the sensors installed on board the device.

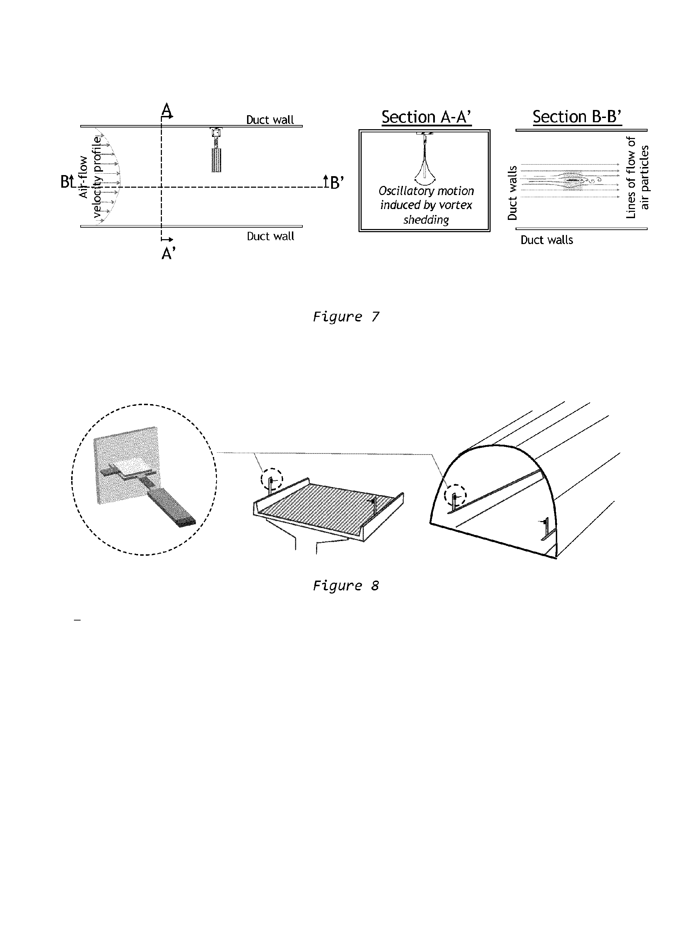

Figure 7 shows an example of positioning of the device according to the invention described so far within an air-flow duct (typical of HVAC systems). In this application, the energy is generated by the flow of air within the air-conditioning duct, and energy production is maximized thanks to exploitation of the vortex-shedding phenomenon.

Figure 8 shows another example in which the invention is installed alongside traffic lanes on viaducts and in tunnels. In these applications, the energy is generated by the flow of air produced by the passage of vehicles. In these cases, energy production is maximized thanks to exploitation of the vibrations induced by turbulent flow.

### Commercial spinoffs

The invention has been devised for supplying energy to sensors commonly used for building-management systems, aimed at energy saving (building automation) and at structural health monitoring (SHM), such as temperature and humidity sensors, quality-of-air sensors, accelerometers, etc.

In a first example of application, the invention can be used as stand-alone device, combined with a temperature and humidity sensor of a known type for monitoring temperature and humidity within HVAC systems. In this case, the data are transmitted via the data-transmission module to a wireless network in order to optimize consumption.

### Bibliography

Nan Wu, QuanWang and XiangdongXie (2013) Wind energy harvesting with a piezoelectric harvester. Smart Mater. Struct. 22, 095023 (9pp) doi:10.1088/0964-1726/22/9/095023
Weinstein, L.A., Cacan, M.R., So, P.M. and Wright, P.K. (2012) Vortex shedding induced energy harvesting from piezoelectric materials in heating, ventilation and air conditioning flows. Smart Mater. Struct. 21, 045003 (10pp) doi:10.1088/0964-1726/21/4/045003

## Claims

1. A self-supplied device for detection of environmental and/or structural parameters and for sending such data in wireless mode, **characterized in that** it comprises, in combination: means for harvesting mechanical energy from the aerodynamic phenomena of vortex shedding, galloping, flutter and/or turbulent-flow-induced vibrations generated by the air flows present in the environment in which the means are installed; means for generating electrical energy by means of piezoelectric technology; means for detection of environmental and/or structural data; and means for sending the data detected in wireless mode; wherein to obtain the maximum vibrations and hence the maximum energy produced, it envisages a fin (d) at least one piezoelectric element (c), the constructional characteristics of which are such as to guarantee the effect of lock-in of the vibrating system, i.e., the phenomenon whereby the vortex-shedding frequency is close to the natural frequency of the oscillating system.

2. The device according to Claim 1, **characterized in that** it comprises:
• a base (a) made of rigid material that serves as support for all the components;
• an electronic element (b), comprising a first module for wireless communication and a second module for energy storage; and
• at least one sensor (e) chosen according to the desired specific application: it may be an environmental sensor, such as for example a temperature and humidity sensor for use within HVAC pipes, and/or a sensor for structural monitoring, such as for example an accelerometer;
wherein said at least one piezoelectric element (c) is constituted by typical energy-harvesting materials, such as for example BaTiO₃, PZT-5A, PZT-5H, polyvinylidene fluoride (PVDF), etc.; and
wherein said mobile fin (d) has dimensions, shape, and mechanical characteristics designed to maximize the effect of vortex shedding and is mechanically connected to said piezoelectric element to cause it to undergo deformation when it is subjected to aerodynamic forces; and
wherein said piezoelectric element (c) is set between said fixed supporting base (a) and said mobile fin (d).

3. The device according to Claim 2, **characterized in that** the piezoelectric element (c) is of the patch type, i.e., in the form of an adhesive layer, attached on a flexible element, on at least one of the surfaces that are subjected to tension/compression on account of bending of the flexible element itself.

4. The device according to Claim 2, **characterized in that** the piezoelectric element (c) is of the free-standing type, i.e., in the form of a self-supporting piezoelectric element.

5. The device according to any one of the preceding claims, **characterized in that** it is positioned in such a way that the major surface of said mobile fin (d) is set parallel the flow of air and **in that** the major length of the fin (d) itself is also set parallel to the flow of air.

6. The device according to any one of the preceding claims, **characterized in that**, in addition to, or instead of, said sensor (e), also a sensor for monitoring chemical substances present in the air is provided.

7. The device according to any one of the preceding claims, **characterized in that** it is equipped with a casing that partially or totally covers the electronic element (b), as well as the sensor (e).

8. The device according to Claim 2, **characterized in that** it envisages an additional mass (f), preferably at the free end of the fin (d), for appropriately adjusting the natural frequency of oscillation of the oscillating parts.
